(19) Europäisches Patentamt
European Patent Office
Office européen des brevets

(11) EP 2 007 016 A1

(12) EUROPEAN PATENT APPLICATION

(43) Date of publication:
24.12.2008 Bulletin 2008/52

(51) Int Cl.:
*H03M 7/40* (2006.01)

(21) Application number: 07110608.2

(22) Date of filing: 20.06.2007

(84) Designated Contracting States:
AT BE BG CH CY CZ DE DK EE ES FI FR GB GR
HU IE IS IT LI LT LU LV MC MT NL PL PT RO SE
SI SK TR
Designated Extension States:
AL BA HR MK RS

(71) Applicant: Deutsche Thomson OHG
30625 Hannover (DE)

(72) Inventor: Streit, Arend
30163 Hannover (DE)

(74) Representative: Rittner, Karsten
Deutsche Thomson OHG
European Patent Operations
Karl-Wiechert-Allee 74
30625 Hannover (DE)

(54) **Method and encoder for variable length encoding of a signal value and method and decoder for decoding a variable length encoded signal value**

(57) The invention is related to variable length encoding of a signal value. The invention is further related to decoding a variable length encoded signal value.

The inventive method for variable length encoding of a signal value comprises the step of determining (20) a multiplier integer wherein the multiplier integer multiplied by a support integer greater than one equals an amount of information units necessary for encoding the signal value. By help of the multiplier integer and of the support integer a reduction value is determined (20). Then, the signal value is reduced by the determined reduction value (20). Finally, the method comprises the steps of encoding (20) the multiplier integer and of encoding (30) the reduced signal value using the determined amount of information units.

The inventive method makes use of information on the signal value. Instead of the signal value a reduced signal value can be encoded. This shortens the data section in average.

Figure 6

**Description**

Background

The invention is related to a method and to an encoder for variable length encoding of a signal value. The invention is further related to a method and to a decoder for decoding a variable length encoded signal value.

A signal is formed by a sequence of signal values. Signals may stem from analogue measurement values. For instance, they may be derived from an image sensor, from a microphone or from an antenna. Or, they may be derived form digitally generated values as used, for example, for an animation, for a computer generated sound or for artificial speech.

A measurement value and/or a digitally generated value are educible as one or more whole numbers depending on whether an integer, a fixed point number or a floating point number shall be represented. Each of said whole-numbers is represented by a signal value. For storage, transmission, broadcasting or processing, signal values are encoded by help of information units. There are two different approaches in encoding: Fixed length coding and variable length coding.

Fixed length coding always uses a data section of the same extent for carrying signal values. That is, the data section is formed by a fixed number of information units. Therefore, the number of different signal values representable by a given fixed length coding is limited. Furthermore, if the number of information units needed for coding a signal value is smaller than the extent of the data section, some information units in the data section remain dull or empty.

Such dull or empty information units are avoided by variable length coding. Additionally, variable length coding is theoretically not limited by any maximal number of different signal values codable. In variable length coding, varying numbers of information units are used for encoding signal values. The information units used for a signal value form a data section of variable extent. The extent of the data section corresponds to the length of the code representing the signal value. To allow decoding of an encoded signal value, the extent of the data section is encoded in a prefix. Thus, the prefix represents the number of information units used for coding the signal value.

To keep the prefix short the allowable extents of the data section may be restricted to be multiples of a support integer. Then, the prefix may represent the respective multiple instead of the actual extent.

The respective multiple is at least one. Therefore, a multiplier integer, which is by one smaller than the multiple, can be encoded in the prefix.

The prefix itself is formed from a variable number of information units. To allow decoding, the prefix is commonly unary coded. That is, the prefix is formed from an amount of information units of equal content wherein the amount equals the multiplier integer. To indicate the end of the prefix and/or the beginning of the data section a separating information unit is appended. The separating information unit has content differing from the content of the unary code. Then, the data section is appended.

Variable length coding is used in a variety of technical applications. For instance, variable length coding is used for encoding visual sensor inputs, for transmission of video or multimedia streams or for storage of audio data, just to name a few.

In order to exploit transmission bandwidths or storage capacities better, there is a need for reducing the average coding length in variable length coding.

Invention

This need is met by the method for variable length encoding of a signal value wherein the method comprises the features of claim 1.

That is, the method comprises the step of determining a multiplier integer wherein the multiplier integer multiplied by a support integer greater than one equals an amount of information units necessary for encoding the signal value. By help of the multiplier integer and of the support integer a reduction value is determined. Then, the signal value is reduced by the determined reduction value. Finally, the method comprises the steps of encoding the multiplier integer and of encoding the reduced signal value using the determined amount of information units.

The inventive method makes use of information on the signal value. This information is contained in the prefix. Knowledge of the prefix comes along with knowledge of a lower bound for the signal value. So, instead of the signal value a value reduced by said lower bound can be encoded. In average, this allows for using a shorter data section.

Preferably, the method further comprises encoding the multiplier integer with the respective number of information units; encoding the reduced signal value binary and concatenating the encoded reduced signal value and the encoded multiplier integer.

It is further preferred, if the multiplier integer comprises comparing the signal value with one or more table values. A table value is comprised in a table entry of a table related to the support integer. Table entries establish a relationship between a first entry value for the multiplier integer and a second entry value for the reduction value.

In another preferred embodiment of the inventive method for encoding a signal value, the reduction value equals a sum of addends wherein an addend equals a base raised to the power of an exponent. The base equals two raised to the power of the support integer and for each counting value greater than 0 and smaller than the multiplier integer, the sum comprises an addend of respective exponent.

The method is further related to a method for decoding a variable length encoded signal value with the features of claim 6.

That is, the method comprises reading one or more information units until an information unit with a pre-defined value is read wherein for each information unit read a counter is incremented. The method further comprises reading an amount of subsequent information units wherein the amount equals the counted number multiplied by a support integer greater than one and decoding a value comprised in the subsequent information units read. Furthermore, determining an add-on value by help of the counted number and of the support integer and determining the signal value by adding the value and the add-on value is comprised in the method.

Preferably, determining the add-on value comprises comparing the counted number with one or more table values wherein a table value is comprised in table entry of a table related to the support integer. The table entries establish a relationship between a first entry value for the counted number and a second entry value for the add-on value.

It is also preferred, if the add-on value equals a sum of addends wherein an addend equals a base raised to the power of an exponent. The base equals two raised to the power of the support integer. For each increment value greater than 0 and smaller than the multiplier integer, the sum comprises an addend of respective exponent.

Furthermore, the invention is related to an encoder for variable length encoding of a signal value and a decoder for decoding a variable length encoded signal value, wherein the decoder comprises the features of claim 9 and the encoder comprises the features of claim 10.

The invention is also related to a signal and to a storage medium wherein said signal and said storage medium, each, comprises an encoded signal value being encoded with any of the inventive methods for variable length encoding of a signal value.

## Drawings

Exemplary embodiments of the invention are illustrated in the drawings and are explained in more detail in the following description.

In the figures:

Fig. 1    shows a flow chart of an exemplary embodiment of the inventive method for variable length encoding of a signal value,

Fig. 2    shows an exemplary embodiment of initialization as being part of the exemplary embodiment of the inventive method shown in figure 1,

Fig. 3    shows an exemplary embodiment of forming a prefix as being part of the exemplary embodiment of the inventive method shown in figure 1,

Fig. 4    shows an exemplary embodiment of binary encoding of the signal value as being part of the exemplary embodiment of the inventive method shown in figure 1,

Fig. 5    shows a flow chart of an exemplary embodiment of the inventive method for decoding a variable length encoded signal value,

Fig. 6    shows an exemplary embodiment of the inventive encoder for variable length encoding of a signal value and

Fig. 7    shows an exemplary embodiment of the inventive decoder for decoding a variable length encoded signal value.

## Exemplary embodiments

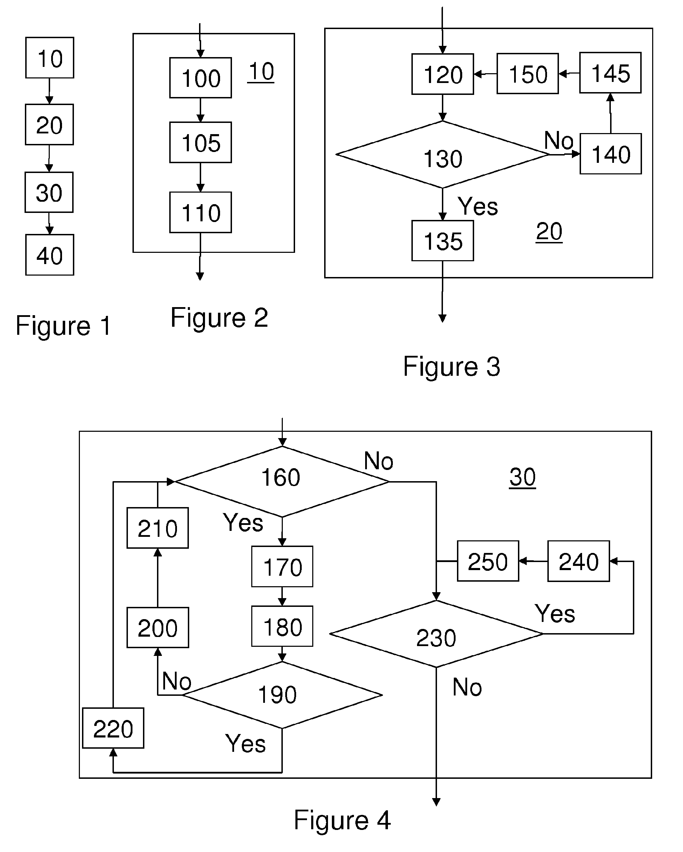

A flow chart of an exemplary embodiment of the inventive method for variable length encoding of a signal value is depicted in figure 1.

The method comprises initialization 10, forming the prefix 20, binary encoding the signal value 30 and outputting the result 40.

The initialization 10 as depicted in figure 2 commences with step 100, the reception of the signal value *I* which has to be encoded. Then in step 105, an output bit string is initialized as an empty bit string of length Zero, for example as a pointer to a bit sting. In a subsequent step 110, a counter value C is initialized to a support integer value S.

Forming a prefix 20 is depicted in detail in figure 3. A reductor R is determined by help of the current counter value C in step 120 according to the following equation:

$$R = 2^C \qquad (1)$$

In step 130 it is checked, whether the reductor R is larger than the current signal value *I*. If not, the method reduces the current signal value *I* by the reductor *R* in step 140 and increases the counter value C in step 145 by the support integer value S. As well, a bit of value 0 is appended to the output bit string in step 150. Then, the method returns to step 120.

Otherwise, in step 135 a bit of value 1 is appended to the output bit string.

Figure 4 shows the binary encoding of the signal value 30 in more detail. First, it is checked in step 160, whether the current signal value *I* is greater than Zero. If so, the counter value C is decremented by 1 in step 170. Then in step 180, the reductor R is actualized by help of the current counter value C according to equation (1).

In step 190 it is checked, whether the reductor R is larger than the current signal value *I*. If not, the method reduces the current signal value *I* by the reductor R in step 200 and appends in step 210 a bit of value 1 to the output bit string. Then, the method returns to step 160.

If the reductor R is larger than the current signal value *I*, steps 200 and 210 are bypassed and a bit of value 0 is appended to the output bit string in step 220. Then, the method returns to step 160.

If in step 160 it is detected that the current signal value *I* is not greater than Zero, the method passes on to step 230. In step 230 it is checked whether the counter value C greater than Zero. If so, a bit of value 0 is appended to the output bit string in step 240. Then, the counter value C is decremented by 1 in step 250 and the method returns to step 230.

If in step 230, it is detected, that the counter value C is not greater than Zero, encoding is finished.

Then, the output bit string is outputted in step 40.

In another exemplary embodiment of the inventive method for variable length encoding of a signal value use of a look-up table is made. The look-up table is related to the value of the support integer S.

In a row or a column of an exemplary embodiment of the look-up table a relationship between a value range lower bound for the signal value *I* and a value for a whole-numbered multiplier M is established. The value range lower bound is also the respective reduction value RV related to the whole-numbered multiplier. The multiplier M corresponds to the length of the prefix and the length of the data section corresponds to *S*M*. The signal value to-be-encoded is reduced by the reduction value RV and encoded in the data section. For a given signal value I greater than Zero, the multiplier M and the reduction value RV can be calculated by help of the following equations:

$$L(I) = \mathrm{int}(\log_2(I)) + 1 \qquad (2)$$

$$L'(I,S) = L + S - L \bmod S \qquad (3)$$

$$M(L',S) = L'/S \qquad (4)$$

and

$$RV(M,S) = \sum_{i=1}^{M-1} (2^S)^i \qquad (5)$$

Within the look-up table the limits of the value ranges are defined by those values for signal value *I* for which *L' (I-1,S)* differs from *L'(I,S)*. The lower bound of the value range is also the corresponding reduction value RV.

This is an example for the look-up table for *S=3 :*

| | |
|---:|---:|
| 0 | 1 |
| 8 | 2 |
| 72 | 3 |
| 584 | 4 |
| 4.680 | 5 |
| 37.448 | 6 |
| 299.592 | 7 |
| 2.396.744 | 8 |
| 19.173.960 | 9 |
| 153.391.688 | 10 |
| 1.227.133.512 | 11 |
| 9.817.068.104 | 12 |
| 78.536.544.840 | 13 |
| 628.292.358.728 | 14 |
| 5.026.338.869.832 | 15 |
| 40.210.710.958.664 | 16 |
| 321.685.687.669.320 | 17 |

This is another example for the look-up table for *S=4*:

| | |
|---:|---:|
| 0 | 1 |
| 16 | 2 |
| 272 | 3 |
| 4.368 | 4 |
| 69.904 | 5 |
| 1.118.480 | 6 |
| 17.895.696 | 7 |
| 286.331.152 | 8 |
| 4.581.298.448 | 9 |
| 73.300.775.184 | 10 |
| 1.172.812.402.960 | 11 |
| 18.764.998.447.376 | 12 |
| 300.239.975.158.032 | 13 |

Within the look-up table examples, the first column contains lower bounds for value ranges which at the same time are the respective reduction values RV. The right column contains the respective integer multiplier M.

A good choice of the support integer S depends on the frequency of appearance of different values in a set of signal values to-be-encoded. If larger values with many digits are more frequent the smaller ones, a larger support integer provides for shorter code. But, if there are mainly values with one or two digits to encode, a smaller support integer yields shorter code. Decision on the support integer might be based on a weighted average of the values to encode, for instance.

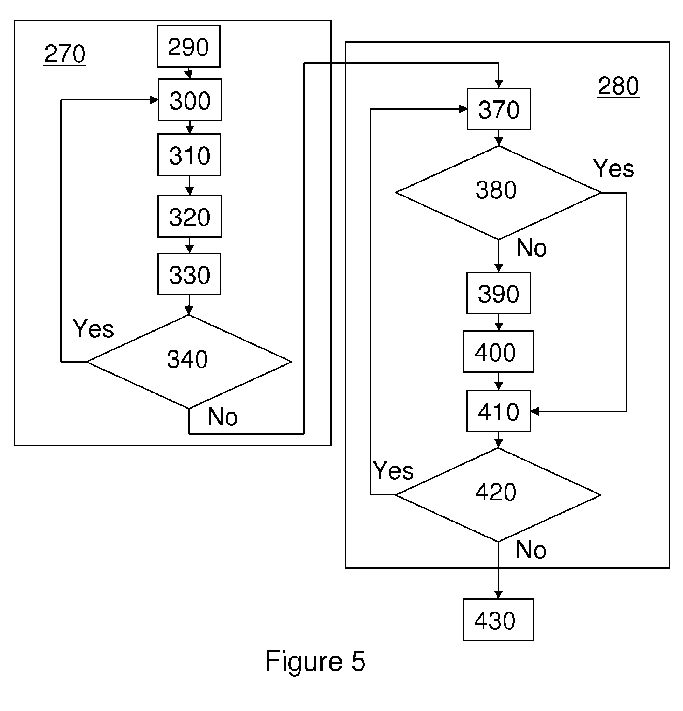

A signal value encoded by the inventive encoding method, could be decoded by the exemplary embodiment of the inventive method for decoding a variable length encoded signal value depicted in figure 5.

The method comprises reading the prefix 270 and reading the signal value 280.

Reading the prefix 270 commences with initialization of a counter value C to 0 and with initialization of an accumulator value AV to -1 in step 290. The method continues with the step 300 of reading a next bit. In step 310, an add-on value A is determined as:

$$A = 2^C \qquad (6)$$

Then, in step 320, the counter value C is incremented by the value of a support integer S. The support integer S has to be the same as the one used for encoding, otherwise decoding will fail. Prior to, simultaneously with or after incrementing the counter value C, the accumulator value AV is increased by the add-on value A in step 330.

In decision step 340 it is checked whether the bit is a Zero bit. If so, the method returns to step 300. Otherwise, the method passes on to reading the signal value 280 which commences with step 370.

In step 370, the next bit is read. Step 380 checks, whether said next bit is Zero. If not, in step 390 the add-on value A is recalculated with the current counter value C according to equation (6).

Then, in step 400 the accumulator value AV is increased by the add-on value A.

If in step 380 it is detected that the next bit is Zero, steps 390 and 400 are bypassed.

Prior to, simultaneously with or after incrementing the accumulator value AV, the counter value C is decremented by one in step 410.

Step 420 checks, whether the counter value C is greater than Zero. If so, the method returns to step 370.

Otherwise, the current accumulator value AV is outputted as the decoded signal value in step 430.

In another exemplary embodiment, use of the look-up tables mentioned above is made. That is, instead of incrementing the accumulator value *AV* in step 310 and 330 it is initialized in between steps 340 and 370. After step 340, the current counter value c is used to look up a value with which the accumulator value AV is initialized.

In a further exemplary embodiment, the support integer used for encoding signal values itself is encoded with a predefined support integer. Then, the support integer encoded as such is transmitted, broadcasted or stored first. The signal values are then encoded by help of said support integer.

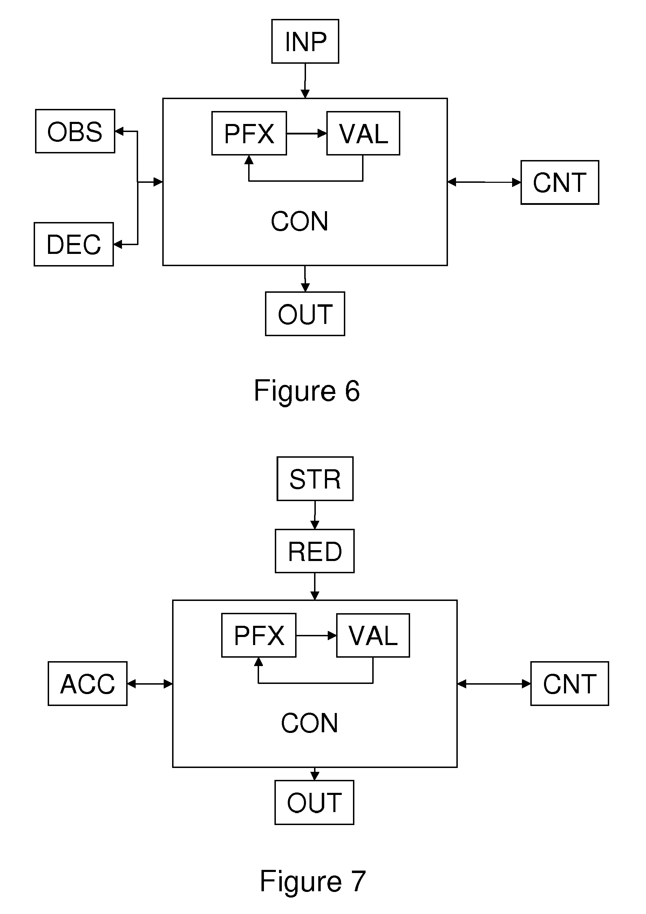

An exemplary embodiment of the inventive method for variable length encoding of a signal value could be performed by an exemplary encoder depicted in figure 6.

The exemplary encoder receives the signal value to-be-coded at its input INP. The encoder also comprises a controller CON and declining means DEC. The declining means DEC subtracts each value received from a decliner value. The decliner value can be initialized and accessed by the controller CON. The controller CON may initialize the value of declining means DEC with the received signal value. The controller CON has also full access to a counter CNT. That is, the controller CON can initialize, read, decrease or increase the value of counter CNT. Furthermore, the controller CON may initialize an output bit string kept in an output bit string buffer OBS as empty bit string of length zero. And, the controller may append bits to the output bit string in the output bit string buffer OBS, one bit at a time. In another exemplary embodiment of the encoder, two or more bits may be appended to the output bit string at a time. The controller can also access the output bit string buffer OBS and pass the output bit string to the encoder output OUT. That is, the output bit string might be, for instance, transmitted or broadcasted as a signal to one or more receiving devices. As another example, the output bit string might be stored in a storage medium like a hard disk, a DVD or a BD-disk.

The controller CON is in one of two states. That is, the controller CON is either in the state PFX of determining and encoding a prefix or in the state VAL of encoding the signal value. Switching between states appears in dependence on the value of the counter CNT and/or on the value of the declining means DEC.

At the very beginning after reception of the signal value to-be-encoded, the controller is in state PFX and initializes the value of counter CNT to the value of a support integer S. As well, the controller initializes the value of the declining means DEC to the signal value.

While being in state PFX, the encoder checks for a current value of counter CNT, whether the current value of the declining means DEC is smaller than a subtraction value. The subtraction value is calculated as two raised to the power of the current value of counter CNT. If the current value of the declining means DEC is not smaller than the subtraction value, the encoder passes the subtraction value to the declining means DEC. And, the controller CNT appends a bit of value 0 to the output bit string in the output bit string buffer OBS. Then, the encoder increases the value of counter CNT by the value of the support integer S.

If the current value of the declining means DEC is smaller than the subtraction value, the controller CNT appends a bit of value 1 to the output bit string in the output bit string buffer OBS. Then, the controller CNT switches to state VAL.

When entering state VAL, the controller CON decrements the value of counter CNT by 1.

While being in state VAL, the controller CON recalculates the subtraction value by help of the current value of counter CNT. Then, it is checked, whether the current value of the declining means DEC is smaller than the subtraction value. If the current value of the declining means DEC is not smaller than the subtraction value, the encoder passes the subtraction value to the declining means DEC. And, the controller CNT appends a bit of value 1 to the output bit string in the output bit string buffer OBS. Then, the encoder increases the value of counter CNT by 1.

If the current value of the declining means DEC is smaller than the subtraction value, the controller CNT appends a bit of value 0 to the output bit string in the output bit string buffer OBS.

Then, the controller CNT checks whether the value of the counter CNT is below Zero. If not, the controller CON returns to recalculation of the subtraction value. Otherwise, the controller CON excess output bit string buffer OBS and outputs the output bit string to the encoder output OUT. Then, it switches back to state PFX.

An exemplary embodiment of the inventive method for decoding a variable length encoded signal value could be performed by an exemplary decoder depicted in figure 7.

The exemplary decoder is adapted to access a stream of information units STR by help of a reading device RED. The stream STR may be received from a transmitting device or as broadcasted stream. In another exemplary embodiment the reading device RED is suitable for accessing information units on a storage medium. The reading device RED reads values of single information units, one at a time, and passed the value read to a controller CON. The controller CON may pass the received value or any other value to accumulating means ACC. The accumulating means ACC add each value received to an accumulator value. The accumulator value can be initialized and accessed by the controller CON. The controller CON has also full access to the value of a counter CNT. That is, the controller CON can initialize, read, decrease or increase the counter CNT.

The controller CON is in one of two states. That is, the controller CON is either in the state PFX of decoding a prefix or in the state VAL of decoding a variable length encoded signal value. Switching between states appears in dependence on the value of counter CNT or on the value of last information unit read.

At the very beginning, the controller is in state PFX and initializes the value of counter CNT to Zero. As well, the controller initializes the accumulator ACC to -1. For each value of an information unit the controller CON receives from the reading device during state PFX, the controller CON passes a value to-be-added to the accumulating means ACC. The value to-be-added is formed by raising 2 to the power of the value of counter CNT. Then, the controller CON increments the value of counter CNT by the value of a support integer. While being in state PFX, the controller CON checks each information unit value received whether it is Zero after incrementing the value of counter CNT. If not, the controller CON switches to state VAL.

When entering state VAL, the controller CON decrements the value of counter CNT by 1.

While being in state VAL, the controller CON checks whether the value of the currently passed information unit equals 1. If so, the controller CON updates the value to-be-added by help of the current value of counter CNT. Then, the controller CON passes the updated value to-be-added to the accumulating means ACC. The value to-be-added is formed by raising two to the power of the current value of counter CNT. For each value of an information unit the controller CON receives from the reading device during state VAL, the controller decrements -after reception- the value of counter CNT by 1.

If the value of counter CNT drops below 0, the controller CON passes the current accumulator value to the output device OUT. Then, the controller switches back to state PFX.

**Claims**

**1.** Method for variable length encoding of a signal value comprising

- determining (20) a multiplier integer wherein the multiplier integer multiplied by a support integer greater than one equals an amount of information units necessary for encoding the signal value;
- determining (20) a reduction value by help of the multiplier integer and of the support integer;
- reducing (20) the signal value by the reduction value;
- encoding (20) the multiplier integer and
- encoding (30) the reduced signal value using the determined amount of information units.

**2.** Method according to claim 1, further comprising

- encoding (20) the multiplier integer with the respective number of information units;
- encoding (30) the reduced signal value binary and
- concatenating the encoded reduced signal value and the encoded multiplier integer.

**3.** Method according to claim 1 or 2, wherein

- Determining (20) the multiplier integer comprises comparing the signal value with one or more table values wherein
- a table value is comprised in table entry of a table related to the support integer and
- table entries establish a relationship between a first entry value for the multiplier integer and a second entry value for the reduction value.

**5.** Method according to any of the preceding claims, wherein

- The reduction value equals a sum of addends wherein

- an addend equals a base raised to the power of an exponent,
- the base equals two raised to the power of the support integer and
- for each counting value greater than 0 and smaller than the multiplier integer, the sum comprises an addend of respective exponent.

**6.** Method for decoding a variable length encoded signal value, the method comprising

- reading (270) one or more information units until a information unit with a pre-defined value is read wherein for each information unit read a counter is incremented;
- reading (280) an amount of subsequent information units wherein the amount equals the counted number multiplied by a support integer greater than one;
- Decoding (270) a value comprised in the subsequent information units read
- Determining (390) an add-on value by help of the counted number and of the support integer and
- Determining the integer by adding (400) the value and the add-on value.

**7.** Method according to claim 6, further comprising

- Determining (390) the add-on value comprises comparing the counted number with one or more table values wherein
- a table value is comprised in table entry of a table related to the support integer and
- table entries establish a relationship between a first entry value for the counted number and a second entry value for the add-on value.

**8.** Method according to any of the preceding claims 6 or 7, wherein

- The add-on value equals a sum of addends wherein
- an addend equals a base raised to the power of an exponent,
- the base equals two raised to the power of the support integer and
- for each increment value greater than 0 and smaller than the multiplier integer, the sum comprises an addend of respective exponent.

**9.** Decoder for decoding a variable length encoded signal value, the decoder comprises

- means for reading (RED) information units;
- a counter (CNT);
- a controller (CON) for controlling reading of information units in dependency on the counter;
- Means for decoding (CON) a value comprised in the sequence of information units read;
- Means for determining (CON) an add-on value by help of a support integer greater than one wherein said means for determining are connected to the counter and
- Means for determining (CON) the integer by adding the decoded value and the add-on value.

**10.** Encoder for variable length encoding of a signal value, the encoder comprising

- means for determining (CON) a multiplier integer such that the multiplier integer multiplied by a support integer greater than one equals an amount of information units necessary for encoding the integer;
- means for determining (CON) a reduction value by help of the multiplier integer and of the support integer;
- means for reducing (DEC) the integer by the reduction value;
- means for encoding (CON) the reduced integer using the determined amount of information units and
- means for encoding (CON) the multiplier integer.

**11.** A signal or a storage medium comprising a variable length encoded signal value wherein the signal value is encoded in accordance to a method which comprises the features of any of the claims 1 to 5.

Figure 1

Figure 2

Figure 3

Figure 4

Figure 5

INP

OBS

PFX → VAL

CON

CNT

DEC

OUT

Figure 6

STR

RED

PFX → VAL

ACC

CON

CNT

OUT

Figure 7

**European Patent Office**

## EUROPEAN SEARCH REPORT

Application Number

EP 07 11 0608

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (IPC) |
| X | FENWICK P.: "Punctured Elias codes for variable-length coding of the integers"[Online] pages 1-15, XP002453751 Retrieved from the Internet: URL:www.firstpr.com.au/audiocomp/lossless/TechRep137.pdf> [retrieved on 2005-04-26] * page 6, line 8 - page 7, line 5 * ----- | 1-11 | INV. H03M7/40 |
| A | COSTANZO A. ET AL: "RFC 1505: Encoding Header Field for Internet Messages" RFC ARCHIVE, [Online] August 1993 (1993-08), XP002453752 Retrieved from the Internet: URL:http://rfc.sunsite.dk/rfc/rfc1505.html > [retrieved on 2007-10-04] * page 22, line 1 - page 30, last line * ----- | 1-11 | |
| A | FIALA E R ET AL: "DATA COMPRESSION WITH FINITE WINDOWS" COMMUNICATIONS OF THE ASSOCIATION FOR COMPUTING MACHINERY, ACM, NEW YORK, NY, US, vol. 32, no. 4, 1 April 1989 (1989-04-01), pages 490-505, XP000213002 ISSN: 0001-0782 * page 504, last paragraph - page 505, paragraph 1 * * page 496, left-hand column, line 32 - line 45 * ----- | 1-11 | TECHNICAL FIELDS SEARCHED (IPC) H03M |
| A | US 6 794 999 B1 (SAID AMIR [US]) 21 September 2004 (2004-09-21) * column 1, line 56 - line 59 * * column 2, line 60 - column 3, line 9 * * column 3, line 18 - line 20 * * figure 2e * ----- | 1-11 | |

The present search report has been drawn up for all claims

| Place of search | Date of completion of the search | Examiner |
|---|---|---|
| Munich | 4 October 2007 | Winkler, Gregor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.** EP 07 11 0608

This annex lists the patent family members relating to the patent documents cited in the above-mentioned European search report.
The members are as contained in the European Patent Office EDP file on
The European Patent Office is in no way liable for these particulars which are merely given for the purpose of information.

04-10-2007

| Patent document cited in search report | | Publication date | Patent family member(s) | | Publication date |
|---|---|---|---|---|---|
| US 6794999 | B1 | 21-09-2004 | EP WO | 1678833 A2 2005043765 A2 | 12-07-2006 12-05-2005 |

For more details about this annex : see Official Journal of the European Patent Office, No. 12/82

EPO FORM P0459